(19) Europäisches Patentamt / European Patent Office / Office européen des brevets

(11) **EP 1 826 905 A1**

(12) **DEMANDE DE BREVET EUROPEEN**

(43) Date de publication:
**29.08.2007 Bulletin 2007/35**

(51) Int Cl.:
*H03K 19/003* (2006.01)    *H03K 17/16* (2006.01)

(21) Numéro de dépôt: **07102197.6**

(22) Date de dépôt: **13.02.2007**

(84) Etats contractants désignés:
**AT BE BG CH CY CZ DE DK EE ES FI FR GB GR HU IE IS IT LI LT LU LV MC NL PL PT RO SE SI SK TR**
Etats d'extension désignés:
**AL BA HR MK YU**

(30) Priorité: **28.02.2006  FR 0601789**

(71) Demandeur: **ATMEL NANTES SA**
**44306 Nantes Cédex 3 (FR)**

(72) Inventeurs:
• **Chatal, Joël**
  **44470 CARQUEFOU (FR)**
• **Bendraoui, Abdellatif**
  **44450 SAINT-JULIEN DE CONCELLES (FR)**

(74) Mandataire: **Verbrugge, Vivien François Emeric**
**CABINET VIDON**
**16 B, Rue de Jouanet**
**35703 Rennes Cedex 7 (FR)**

(54) **Dispositif électronique de pilotage d'une charge externe dont la pente du signal de sortie est indépendante de la capacité de la charge externe et composant intégré correspondant**

(57)    L'invention concerne un dispositif électronique de pilotage (500) d'une charge externe (C5) recevant, en entrée un signal d'entrée et délivrant en sortie à la charge externe, un signal de sortie.

Selon l'invention, un tel dispositif électronique de pilotage comprend des moyens de réduction de la dépendance de la pente (en Anglais « slew rate ») du signal de sortie à la capacité de la charge externe (C5).

Fig. 5

EP 1 826 905 A1

**Description**

**1. Domaine de l'invention**

Le domaine de l'invention est celui des circuits d'interface (« buffers » en anglais) de sortie. De tels circuits d'interface sont bien connus de l'art antérieur. Ils sont places à la périphérie d'un circuit intégré et sont utilisés pour interfacer des signaux électriques depuis le coeur du circuit vers l'extérieur du circuit. Un circuit intégré comprend généralement plusieurs circuits d'interface de sortie.

L'invention s'applique notamment aux circuits d'interface de sortie présentant une pente du signal de sortie contrôlée.

**2. Solutions de l'art antérieur**

En effet, la plupart des circuits d'interface de sortie comprennent une fonction de contrôle permettant d'ajuster la pente maximale (ou « slew rate » en anglais) de la tension de sortie en réponse à un échelon en tension appliqué en entrée du circuit d'interface.

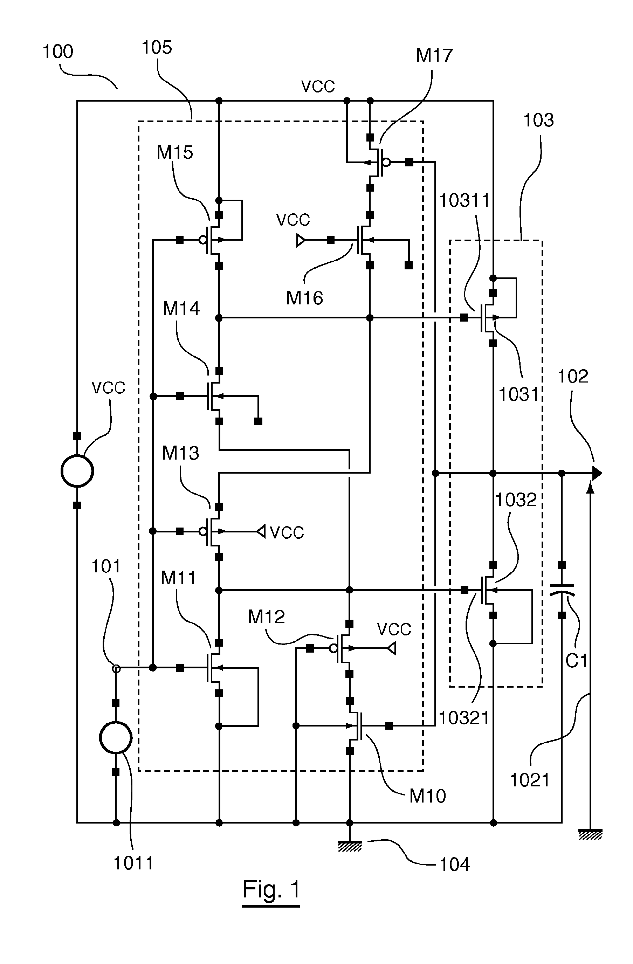

On présente, en relation avec la *figure 1,* le schéma électrique d'un circuit d'interface de sortie 100 classique et conforme a l'état de l'art. Ce circuit d'interface de sortie 100 est alimenté par une alimentation VCC et comprend une entrée 101 sur laquelle on applique un signal d'entrée 1011 et une sortie 102 sur laquelle on peut mesurer la pente maximale (ou « slewrate » en anglais) à partir de la tension du signal de sortie 1021 mesurée aux bornes de la capacité C1 d'une charge (disposée entre le potentiel de sortie 102 et la masse 104).

Ce circuit d'interface de sortie 100 comprend un étage de sortie 103 comprenant lui-même un premier transistor de sortie 1031 de type PMOS et un second transistor de sortie 1032 de type NMOS.

Le circuit d'interface de sortie 100 comprend également un bloc 105 comprenant huit transistors M10 à M17 (le bloc 105 étant alimenté par la tension d'alimentation VCC). Ce bloc de traitement 105 assure le contrôle de la pente maximale du signal de sortie 103. A partir du signal d'entrée 1011, il délivre la commande des première 10311 et seconde 10321 grilles des premier 1031 et second 1032 transistors de l'étage de sortie 103.

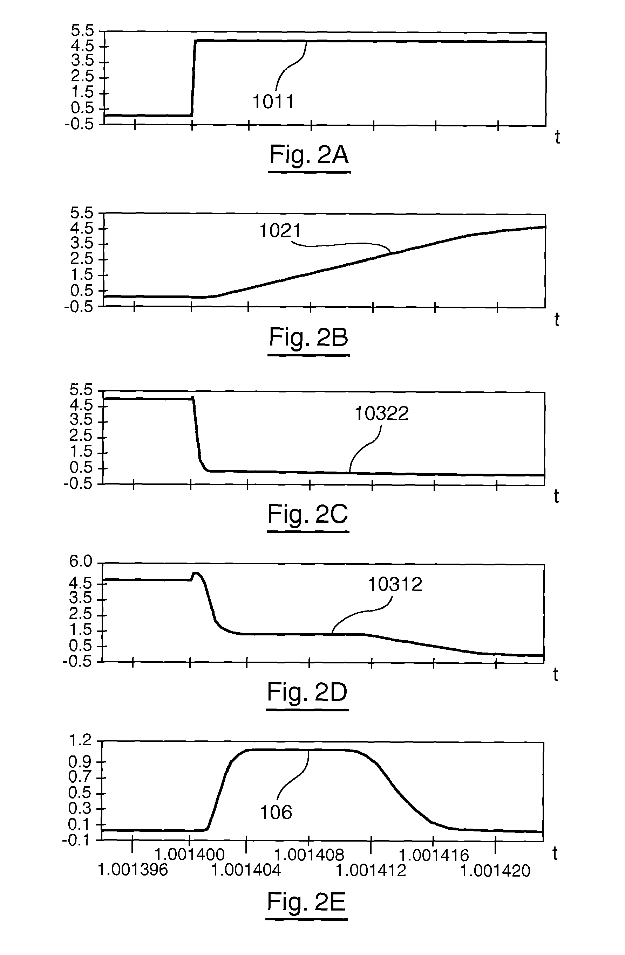

On présente, en relation avec les *figures 2A à 2E,* des courbes en fonction du temps t (en millisecondes) de la tension de sortie 1021 (figure 2B), des première 10312 (figure 2D) et seconde 10322 (figure 2C) tensions de grille et du courant 106 (figure 2E) du drain du transistor M17 du circuit d'interface de sortie de la figure 1 en réponse à un signal d'entrée 1011 sous la forme d'un échelon de tension passant de 0 à VCC (figure 2A).

Les courbes de tensions sont représentées en V et le courant 106 en mA. Les échelles de temps des courbes des figures 2A à 2D sont les mêmes que celle de la courbe de la figure 2E.

L'échelon (figure 2A) de tension de 0 à VCC appliqué à l'entrée 101 correspond à une transition d'un 0 logique à un 1 logique.

A partir d'une telle transition d'un 0 logique à un 1 logique au niveau du signal d'entrée 1011, le transistor M11 devient passant et la seconde tension de grille 10322 chute rapidement de VCC à 0 (tel qu'illustré par la figure 2C).

Du fait que la tension de sortie 1021 est nulle avant la transition, le transistor M17 est passant au moment de la transition. Ainsi, la somme des résistances internes des transistors M17 et M16 forme avec la résistance interne du transistor M14 un pont diviseur de tension qui freine la chute de la première tension de grille 10312 (palier sur la figure 2D) et freine l'augmentation du courant de drain du premier transistor de sortie 1031. Le courant dans le pont diviseur est illustré par le courant 106 du drain du transistor M17 (figure 2E).

Ceci a pour conséquence de limiter la pente du signal de sortie 1021.

Lorsque le niveau de tension de sortie atteint une valeur suffisante, le transistor M17 se coupe et le courant 106 du drain du transistor M17 chute à 0 (figure 2E). Le signal 10311 appliqué à la grille du transistor de sortie 1031 passe à 0.

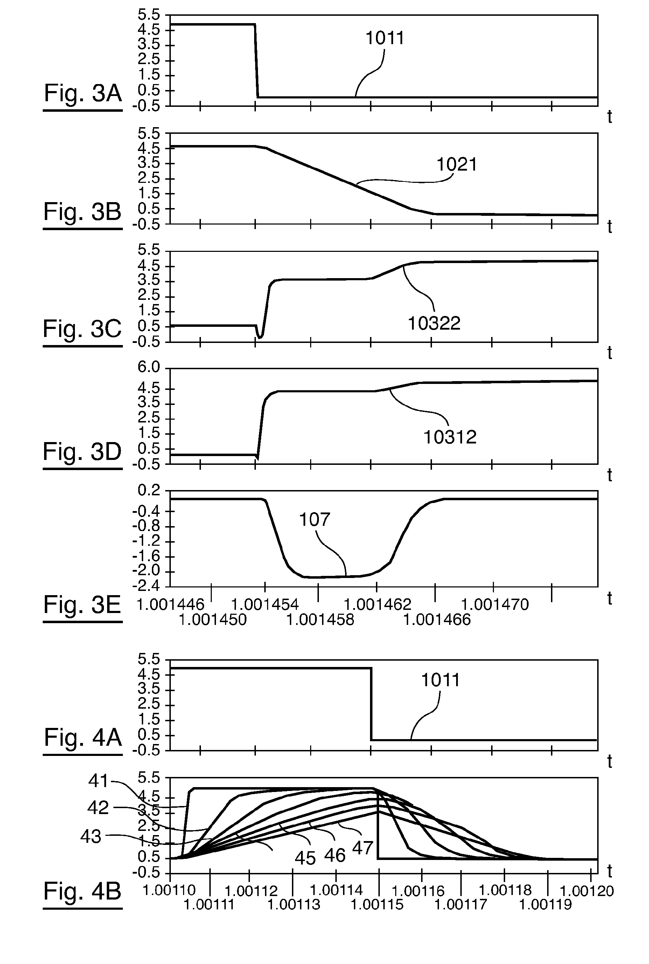

On présente, en relation avec les *figures 3A à 3E,* des courbes en fonction du temps t (en millisecondes) de la tension de sortie 1021 (figure 3B), des première 10312 (figure 3D) et seconde 10322 (figure 3C) tensions de grille et du courant 107 (figure 3E) du drain du transistor M10 du circuit tampon de sortie de la figure 1 en réponse à un signal d'entrée 1011 sous la forme d'un échelon de tension passant de 5V (VCC) à 0V (figure 3A).

Les courbes de tensions sont représentées en V et le courant 107 en mA. L'échelle de temps des courbes des figures 3A à 3D sont les mêmes que celle de la courbe de la figure 3E.

L'échelon (figure 3A) de tension de VCC à 0 appliqué à l'entrée 101 correspond à une transition d'un 1 logique à un 0 logique.

A partir d'une telle transition d'un 1 logique à un 0 logique au niveau du signal d'entrée 1011, le transistor M15 devient passant et la première tension de grille 10312 monte rapidement de 0 a VCC (tel qu'illustré par la figure 3D).

Du fait que la tension de sortie 1021 est a VCC avant la transition, le transistor M10 est passant au moment de la transition. Ainsi, la somme des résistances internes des transistors M10 et M12 forme avec la résistance interne du transistor M13 un pont diviseur de tension qui freine la montée de la deuxieme tension de grille 10322 (palier sur la figure 3C) et freine l'augmentation du courant de drain du second transistor de sortie 1032. Le courant dans le pont diviseur est illustre par le courant 107 du drain du transistor M10 (figure 3E)

Ceci a pour conséquence de limiter la pente du signal de sortie 1021.

Lorsque le niveau de tension de sortie atteint une valeur suffisante, le transistor M10 se coupe et le courant 107 du drain du transistor M10 chute à 0 (figure 3E). Le signal 10322 appliqué à la grille du transistor de sortie 1032 passe à1.

On présente, en relation avec les **figures 4A et 4B**, des courbes 41, 42, 43, 44, 45, 46 et 47 en fonction du temps t (en millisecondes) de la tension de sortie 1021 (figure 4B) du circuit d'interface de sortie 100 en réponse à un signal d'entrée 1011 sous la forme d'un échelon de tension de 0 à VCC (figure 4A) respectivement pour des capacités C1 valant 0pF, 50pF, 100pF, 150pF, 200pF, 250pF et 300pF.

Les courbes de tensions sont représentées en V. L'échelle de temps de la courbe de la figure 3A est la même que celle de la courbe de la figure 3B.

Lorsque la capacité C1 augmente, le pont diviseur formé par la somme des résistances internes des transistors M17 et M16 et par la résistance interne du transistor M14 limite la chute de la première tension de grille 10312 et l'augmentation du courant de drain du premier transistor de contrôle 1031 quelque soit la valeur de C1.

Lorsque la capacité C1 augmente, le pont diviseur formé par la somme des résistances internes des transistors M10 et M12 et par la résistance interne du transistor M13 limite l'augmentation de la seconde tension de grille 10322 et l'augmentation du courant de drain du second transistor de contrôle 1032 quelque soit la valeur de C1.

On peut noter que lors d'une transition de 0 à VCC, l'expression suivante est vérifiée :

$$V_{sortie} = I_{dp} \cdot t / C_1 \quad (1)$$

où $V_{sortie}$ est la tension de sortie 1021, $I_{dp}$ est le courant de drain du premier transistor de contrôle 1031 et t est le temps.

La tension $V_{gs}$ appliquée sur la grille du transistor 1031 de l'étage de sortie ne dépend que du pont diviseur formé par les transistors M16, M17 et M14.

Lors d'une transition de VCC à 0, l'expression suivante est vérifiée :

$$V_{sortie} = I_{dn} \cdot t / C_1 \quad (2)$$

où $I_{dn}$ est le courant de drain du second transistor de contrôle 1032.

Or le courant de drain $I_d$ d'un transistor est donné par l'expression suivante :

$$I_d = K \cdot W / L \cdot (V_{gs} - V_t) \quad (3)$$

où K et $V_t$ sont des constantes dépendant du procédé de fabrication du transistor, $V_{gs}$ est la tension entre la grille et la source du transistor et W et L sont respectivement la largeur et la longueur du canal du transistor.

La tension $V_{gs}$ appliquée sur la grille du transistor 1032 de l'étage de sortie ne dépend que du pont diviseur formé par les transistors M10, M12 et M13.

Ainsi, les relations (1), (2) et (3) montrent que la pente maximale de la tension de sortie 1021 dépend de la capacité C1 de la charge en sortie du circuit 100 (tel que cela est illustré par la figure 4B) et dépend également des paramètres du procédé de fabrication des premier 1031 et second 1032 transistors de contrôle.

Or, cette dépendance de la tension de sortie de la capacité C1 de la charge est pénalisante dans le cadre de la réalisation d'un circuit d'interface de sortie.

Notamment, tel qu'illustré par la figure 4B, lorsque la valeur de la capacité de la charge en sortie est faible, la pente maximale du signal de sortie est importante, ce qui conduit à la génération d'un niveau de bruit important par le circuit d'interface de sortie 100.

Ce niveau de bruit important risque de perturber le fonctionnement d'autres dispositifs en périphérie du circuit d'interface de sortie 100. Ceci est particulièrement gênant, par exemple dans le domaine de l'électronique embarquée, et défavorable à la CEM (pour Compatibilité Electro-Magnétique).

**3. Objectifs de l'invention**

L'invention a notamment pour objectif de pallier ces inconvénients de l'art antérieur.

Plus précisément, un objectif de l'invention, dans au moins un de ses modes de réalisation, est de fournir une technique permettant de réduire la dépendance de la pente maximale du signal de sortie d'un circuit d'interface de sortie, par rapport à la capacité de la charge placée en sortie du circuit.

Il est à noter que la formulation de cet objectif est, en elle-même, nouvelle est inventive car l'homme du métier du domaine des circuits d'interface de sortie n'a jamais envisagé de réduire les problèmes liés à la dépendance de la capacité de la charge en utilisant une telle architecture.

Un autre objectif de l'invention, dans au moins un de ses modes de réalisation, est de mettre en oeuvre un tel circuit qui permettent de fournir un courant statique important à la charge.

L'invention, dans au moins un de ses modes de réalisation, a encore pour objectif de fournir un tel circuit qui génère un bruit réduit par rapport aux circuits d'interface de sortie classiques.

L'invention, dans au moins un de ses modes de réalisation, a encore pour objectif de fournir un tel circuit qui soit simple à réaliser et pour un faible coût.

**4. Exposé de l'invention**

Ces objectifs, ainsi que d'autres qui apparaîtront par la suite, sont atteints à l'aide d'un dispositif électronique de pilotage d'une charge externe recevant, en entrée un signal d'entrée et délivrant en sortie à la charge externe, un signal de sortie.

Selon l'invention, un tel dispositif comprend des moyens de programmation et de réduction de la dépendance de la pente (ou « slew rate ») du signal de sortie à la capacité de la charge externe.

Le principe général de l'invention repose sur la mise en oeuvre dans un dispositif électronique de pilotage d'une charge externe d'un module électronique permettant de réduire, voir même de s'affranchir de la dépendance de la pente maximale du signal de sortie du dispositif par rapport à la capacité de la charge du dispositif.

Avantageusement, les moyens de réduction de la dépendance de la vitesse de balayage du signal de sortie à la capacité de la charge externe comprennent :

- un générateur de rampe programmable comprenant au moins une entrée sur laquelle est appliqué le signal d'entrée, le générateur de rampe délivrant un signal, dit signal délivré par le générateur de rampe, et
- des moyens de traitement rétroactif de ce signal de sortie tenant compte de la différence entre le signal de sortie et le signal délivré par le générateur de rampe et visant à égaliser sensiblement le signal de sortie avec ledit signal délivré par le générateur de rampe.

Ainsi, à partir d'un générateur de rampe programmable délivrant un signal d'impulsion présentant des pentes de montée et descente déterminées et indépendantes de la capacité de la charge externe et de moyens de traitement rétroactifs du signal de sortie comparant le signal de sortie avec le signal délivré par le générateur de rampe, le signal de sortie du dispositif électronique est rendu indépendant de la capacité de la charge.

Préférentiellement, les moyens de traitement rétroactif comprennent des moyens d'amplification de la différence entre le signal de sortie et le signal délivré par le générateur de rampe.

Selon une caractéristique préférentielle de l'invention, les moyens d'amplification comprennent au moins un premier amplificateur différentiel comprenant des transistors de type P et un second amplificateur différentiel comprenant des transistors de type N.

Selon un aspect avantageux de l'invention, des première et seconde paires différentielles respectivement desdits premier et second amplificateurs sont reliées respectivement :

- à des première et troisième sources de courant statique et
- à des seconde et quatrième sources de courant controlées par des premier et second signaux dynamiques,

et lorsque la différence d'amplitude entre le signal de sortie et le signal délivré par le générateur de rampe est supérieure à un premier seuil prédéterminé, les premier et second signaux dynamique prennent respectivement des première et seconde valeurs permettant réduire le temps de réponse des moyens d'amplification..

Ainsi, par exemple, lors des transitions du signal de sortie qui se caractérisent généralement par le fait que le signal de sortie s'écarte en amplitude du signal délivré par le générateur de rampe du fait que la pente des signaux de montée ou de descente du dispositif électronique est limitée, les signaux de tension dynamique sont mis en oeuvre afin d'augmenter la pente des signaux de montée et de descente en sortie du dispositif.

Préférentiellement, les moyens de traitement comprennent en outre des moyens de génération des premier et second signaux dynamiques à partir de la différence entre le signal de sortie et le signal délivré par le générateur de rampe.

Avantageusement, les moyens de génération des premier et second signaux dynamiques comprennent des moyens de comparaison d'un premier courant dépendant de la différence entre le signal de sortie et le signal délivré par le générateur de rampe et d'un second courant de référence de sorte que :

- lorsque la différence d'amplitude entre le premier courant et le second courant est supérieure ou égale à un second seuil, alors les premier et second signaux dynamiques prennent lesdites première et seconde valeurs.

Ainsi, préférentiellement, les signaux de tension dynamiques changent de niveau logique lorsque le signal de sortie s'écarte du signal d'impulsion, c'est-à-dire essentiellement lors des brusques variations du signal d'entrée (par exemple lors des transitions du signal de sortie d'un niveau bas à un niveau haut ou inversement).

Par exemple, le second seuil peut être égal à 1uA.

Selon une caractéristique préférentielle de l'invention, le dispositif électronique comprenant des premier et second transistors de sortie dont les drains sont reliés à ladite sortie, les moyens d'amplification comprennent des premier et second interrupteurs qui :

- connectent l'entrée respectivement aux grilles des premier et second transistors de sortie, lorsque la différence d'amplitude entre le signal de sortie et le signal délivré par le générateur de rampe est inférieure audit premier seuil ;
- connectent des première et seconde sorties amplifiés respectivement desdits premier et second amplificateurs aux grilles des premier et second transistors de sortie, lorsque la différence d'amplitude entre le signal de sortie et le signal délivré par le générateur de rampe est supérieure ou égale audit premier seuil.

Ainsi, la connexion des première et seconde sorties amplifiés respectivement desdits premier et second amplificateurs aux grilles des premier et second transistors de sortie permet notamment aux moyens d'amplification d'asservir la tension de sortie au signal généré par le générateur de rampe pour des charges capacitives élevées sur cette sortie.

Ainsi, lorsque l'on est situé entre deux transitions du signal d'entrée, les transistors de sortie (formant l'étage de sortie) sont équivalents à un montage « inverseur » connecté au signal d'entrée. Ceci permet au dispositif électronique de pilotage de générer en sortie des niveaux haut et des niveaux bas proches des rails d'alimentation. En conséquence, La connexion de l'entrée respectivement aux grilles des premier et second transistors de sortie permet notamment de réduire la consommation statique du circuit d'interface de sortie.

Avantageusement, lorsque la différence d'amplitude entre le signal de sortie et le signal délivré par le générateur de rampe est supérieure ou égale audit premier seuil, un circuit d'interface de sortie, comprenant les moyens d'amplification et lesdits premier et second transistors de sortie, forme un amplificateur suiveur dont l'entrée est reliée au signal délivré par le générateur de rampe et dont la sortie coïncide avec la sortie du dispositif électronique de pilotage.

Ainsi, lors d'une transition du signal d'entrée, les moyens d'amplification et l'étage de sortie forment un circuit d'interface de sortie qui est équivalent à un « amplificateur suiveur » dont l'entrée est reliée au signal délivré par le générateur de rampe et dont la sortie coïncide avec la sortie du circuit d'interface de sortie. Ceci permet d'asservir la pente de montée et de descente de la sortie à la pente de montée et de descente du signal délivré par le générateur de rampe.

Préférentiellement, les premier et second seuils sont tels que lorsque la différence d'amplitude entre le signal de sortie et le signal délivré par le générateur de rampe est supérieure ou égale audit premier seuil, alors la différence d'amplitude entre les premier et second courants est supérieure au second seuil et en ce que lorsque la différence d'amplitude entre le signal de sortie et le signal délivré par le générateur de rampe est inférieure audit premier seuil, alors la différence d'amplitude entre les premier et second courants est inférieure au second seuil.

Avantageusement, le générateur de rampe programmable comprend une source de courant.

L'invention concerne également un composant intégré comprenant un dispositif électronique de pilotage d'une charge externe tel que précédemment décrit.

## 5. Liste des figures

D'autres caractéristiques et avantages de l'invention apparaîtront plus clairement à la lecture de la description suivante d'un mode de réalisation préférentiel, donné à titre de simple exemple illustratif et non limitatif, et des dessins annexés, parmi lesquels :

- la figure 1 présente un schéma électrique d'un circuit d'interface de sortie 100 classique ;
- les figures 2A à 2E présentent des courbes relatives à ce circuit d'interface de sortie 100 classique en fonction du temps de la tension de sortie (figure 2B), des première (figure 2D) et seconde (figure 2C) tensions de grille et du courant (figure 2E) du drain du transistor M 17 du circuit de la figure 1 en réponse à un échelon de tension passant de 0 à 5V (figure 2A) ;
- les figures 3A à 3E présentent des courbes relatives à ce circuit d'interface de sortie 100 classique en fonction du temps de la tension de sortie (figure 3B), des première (figure 3D) et seconde (figure 3C) tensions de grille et du courant (figure 3E) du drain du transistor M10 du circuit de la figure 1 en réponse à un échelon de tension passant de 5 à 0V (figure 3A) ;
- les figures 4A et 4B présentent des courbes relatives à ce circuit d'interface de sortie 100 classique en fonction du temps de la tension de sortie (figure 4B) du circuit de la figure 1 en réponse à un échelon de tension (figure 4A) pour différentes valeurs de la capacité de la charge ;
- la figure 5 présente une architecture complète d'un circuit d'interface de sortie qui comprend des moyens de réduction de la dépendance de la pente maximale de son signal de sortie par rapport à la capacité de la charge selon un mode de réalisation préférentiel de l'invention ;
- la figure 6 présente un schéma d'un mode de réalisation conforme à l'invention du générateur de rampe programmable du circuit d'interface de sortie de la figure 5 ;
- la figure 7 présente un schéma simplifié d'un mode de mise en oeuvre conforme à l'invention des moyens de traitement rétroactifs du signal de sortie comparant le signal de sortie avec le signal délivré par le générateur de rampe du circuit d'interface de sortie de la figure 5 ;
- la figure 8 présente un schéma d'un mode de réalisation des moyens de génération des premier et second signaux dynamiques à partir de la différence entre le signal de sortie et le signal délivré par le générateur de rampe du circuit d'interface de sortie de la figure 5 ;
- les figures 9A à 9E présentent des courbes en fonction du temps t (en microsecondes) du signal délivré par le générateur de rampe (figure 9B), du premier signal dynamique (figure 9C), du signal de sortie 5021 (figure 9D) et du courant de la charge du circuit d'interface de sortie de la figure 5 en réponse à un signal d'entrée (figure 9A) ;

- la figure 10 présente des courbes en fonction du temps t de la tension de sortie du circuit d'interface de sortie de la figure 5 en réponse à un échelon de tension pour des charges dont la capacité vaut 0pF, 50pF, 100pF, 150pF, 200pF, 250pF et 300pF.

## 6. Description d'un mode de réalisation de l'invention

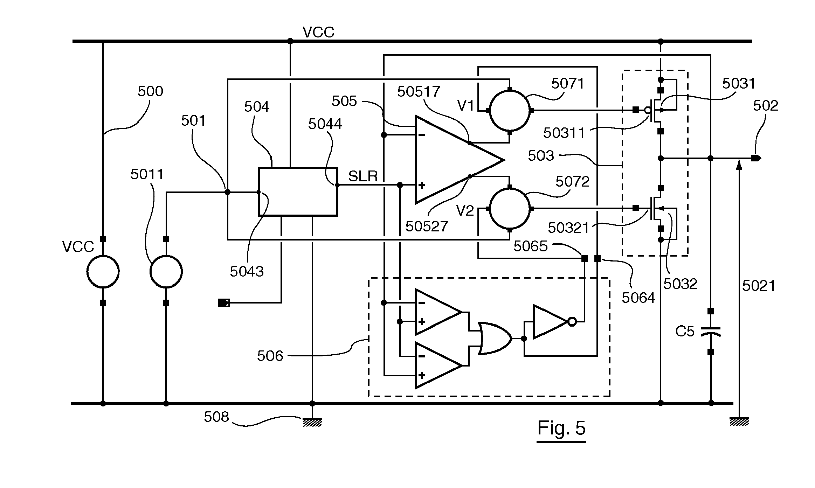

On présente, en relation avec la **figure 5,** un dispositif électronique de pilotage (qui est par exemple un circuit d'interface de sortie ou un buffer) d'une charge externe C5 qui comprend des moyens de réduction de la dépendance de la pente maximale de son signal de sortie par rapport à la capacité de la charge selon un mode de réalisation préférentiel de l'invention.

Ce circuit d'interface de sortie 500 est alimenté au moyen d'une alimentation VCC qui est par exemple égale à 5V. La référence des potentiels de ce circuit 500 est la masse 508.

Il comprend une entrée 501 sur laquelle est appliqué un signal d'entrée 5011 et une sortie 502 délivrant un signal de sortie 5021 à la charge C5 (qui est par exemple une capacité de 50 pF).

Ce circuit d'interface de sortie 500 comprend également un étage de sortie 503 comprenant un premier transistor de sortie 5031 de type PMOS et un second transistors de sortie 5032 de type NMOS (les transistors de sortie peuvent être également appelés « étage de sortie ») dont les drains sont connectés à la sortie 502. La source du premier transistor de sortie 5031 est reliée à l'alimentation VCC et celle du second transistor de sortie 5032 est reliée à la masse 508.

Les moyens de réduction de la dépendance de la pente maximale du signal de sortie 5021 par rapport à la capacité de la charge C5 comprennent

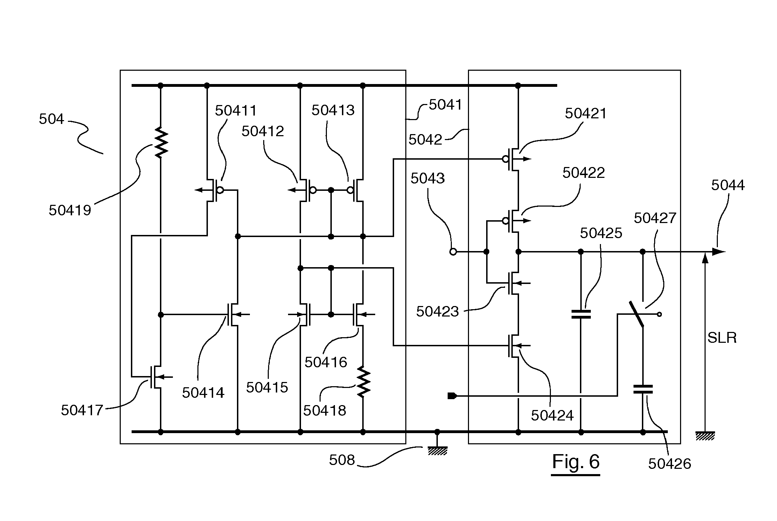

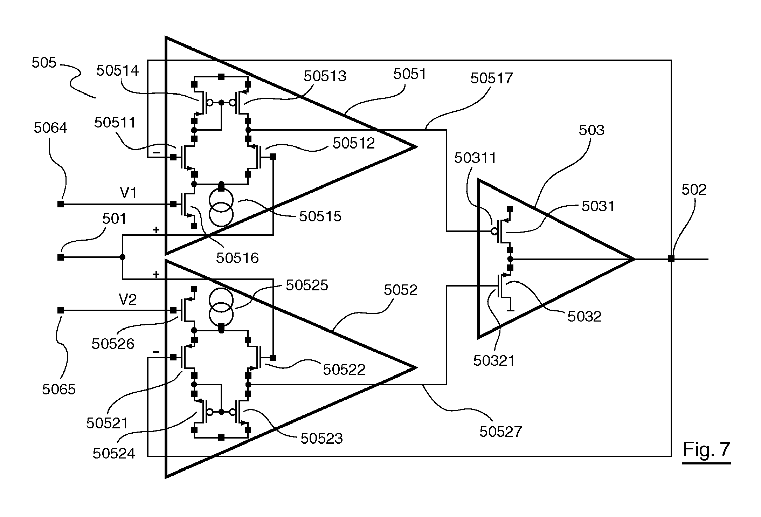

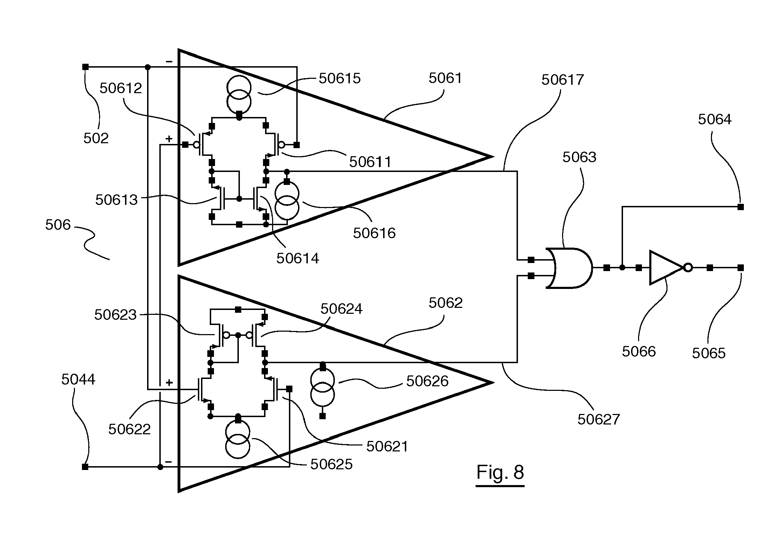

- un générateur de rampe 504 (décrit ci-après en relation avec la figure 6) comprenant une entrée 5043 sur laquelle est appliquée le signal d'entrée 5011 et une sortie 5044 par laquelle il délivre un signal SLR présentant des pentes de montée et de descente réglables ;
- des moyens de traitement rétroactifs du signal de sortie 5021 (visant à égaliser sensiblement le signal de sortie 5021 avec le signal SLR comprenant eux-mêmes :
  - des moyens d'amplification 505 (décrits ci-après, en relation avec la figure 7) de la différence entre le signal de sortie 5021 et le signal d'impulsion SLR comprenant un premier amplificateur 5051 à base de transistors MOS de type P et un second amplificateur 5052 à base de transistors MOS de type N ;
  - des moyens de génération 506 (décrits ci-après en relation avec la figure 8) de premier V1 et second V2 signaux de tension dynamiques à partir de la différence entre le signal de sortie 5021 et le signal SLR.

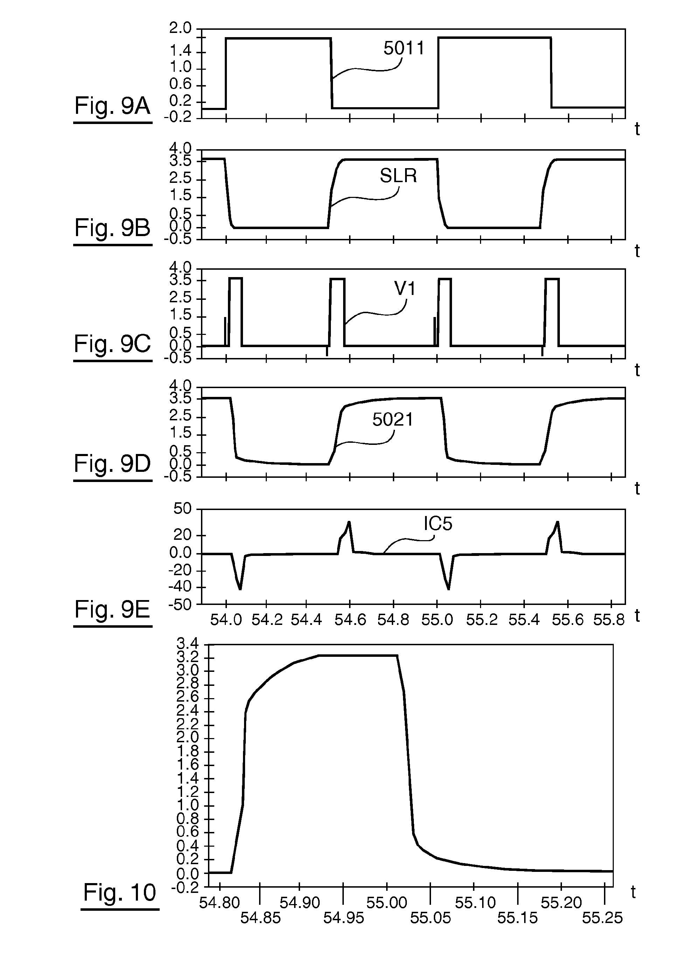

Les moyens d'amplification comprennent des premier 5071 et second 5072 interrupteurs (dont le fonctionnement est décrit ci-après, en relation avec les figures 9A à 9E) contrôlés par les premier et second signaux de tension dynamiques.

Les moyens d'amplification 505 présentent deux modes de fonctionnement. Ces deux modes de fonctionnement, qui sont sélectionnés grâce aux premier 5071 et second 5072 interrupteurs, sont :

- un « mode dynamique » pendant lequel les premier 5071 et second 5072 interrupteurs sont activés de façon que des première 50517 et seconde 50527 sortie amplifiée soient reliées respectivement aux grilles 50311, 50321 des premier 5031 et second 5032 transistors de sortie de l'étage de sortie 503. Dans ce cas, les moyens d'amplification 505 se comportent globalement comme un amplificateur en mode suiveur. L'entrée positive de cet amplificateur est reliée au signal SLR, l'entrée négative est reliée à la sortie 502 du circuit d'interface de sortie ;
- un « mode statique » pendant lequel les premier 5071 et second 5072 interrupteurs sont activés de façon que l'entrée 501 du générateur de rampe 504 soit reliée directement aux grilles 50311, 50321 des premier 5031 et second 5032 transistors de sortie de l'étage de sortie 503.

Ainsi tel qu'expliqué ci-après, en relation avec les figures 9A à 9E, les premier V1 et second V2 signaux de tension dynamiques sont élaborés à partir de la différence entre le signal de sortie 5021 et le signal SLR. Quand la différence entre le signal de sortie 5021 et le signal SLR devient supérieure à une valeur seuil, l'amplificateur 505 fonctionne en mode dynamique.

On présente, en relation avec la **figure 6**, un générateur de rampe 504 selon le mode de mise de réalisation préférentiel de l'invention.

Le générateur d'impulsion 504 comprend :

- un générateur de rampe programmable 5042 classique qui est par exemple réalisé (tel qu'illustré par la figure 6) à partir de transistors 50421 à 50424 montés en « inverseur contrôlé en courant », dont la sortie est reliée à un premier condensateur 50425. Un deuxième condensateur 50426 peut être monté en parallèle avec le condensateur 50425, si l'interrupteur 50427 est passant, ce qui permet de faire varier la capacité globale a la sortie de l'inverseur, et de faire varier les pentes de montée et de descente du signal SLR.

- une source de courant 5041 classique qui est par exemple réalisée à partir de transistors 50411 à 50417 et à partir de résistances 50418 et 50419 (qui valent, par exemple, respectivement 30k Ω, et 1M Ω) tel qu'illustré par la figure 6.

La référence des potentiels de ce générateur de rampe 504 est la masse 508.

Ainsi, le générateur de rampe 504 délivre en sortie 5044 le signal SLR dont les pentes de montée et de descente sont réglables.

On présente, en relation avec la *figure 7,* les moyens d'amplification 505 ainsi que l'étage de sortie 503 selon un mode de mise en oeuvre préférentiel de l'invention.

Le schéma de la figure 7 est simplifié, par rapport a celui de la figure 5, il ne comprend pas les premier 5071 et second 5072 interrupteurs. Ce schéma est un schéma équivalent de l'étage 505 de la figure 5, pendant le mode dynamique.

Les moyens d'amplification 505 comprennent les premier 5051 et second 5052 amplificateurs précités.

Le premier amplificateur 5051 est un amplificateur différentiel classique comprenant une première paire différentielle de transistors 50511, 50512 de type N ainsi que deux autres transistors 50513, 50514 de type P. La grille du transistor 50511 de la première paire différentielle est reliée à la sortie 502 du circuit d'interface de sortie et la grille du transistor 50512 de la première paire différentielle est reliée à l'entrée 501 des moyens d'amplification 505.

La première paire différentielle 50511, 50512 du premier amplificateur 5051 est reliée a :

- une première source de courant 50515 délivrant un courant statique (délivrant par exemple un courant de 1 μA) ;
- une deuxième source de courant réalisée au moyen d'un transistor 50516 de type N. Ce transistor 50516 est contrôlé par le premier signal dynamique V 1. La deuxième source de courant n'est activée que lorsque les moyens d'amplification 505 présentent le « mode dynamique », ceci afin de limiter le courant à travers la première paire différentielle 50511, 50512 lorsque les moyens d'amplification 505 sont en « mode statique ».

Le second amplificateur 5052 est un amplificateur différentiel classique comprenant une seconde paire différentielle de transistors 50521, 50522 de type P ainsi que deux autres transistors 50523, 50524 de type N. La grille du transistor 50521 de la seconde paire différentielle est reliée à la sortie 502 du circuit d'interface de sortie et la grille du transistor 50522 de la seconde paire différentielle est reliée à l'entrée 501 des moyens d'amplification 505.

Le second amplificateur 5052 est alimenté par :

- une troisième source de courant 50525 délivrant un courant statique (délivrant par exemple un courant de 1 μA) ;
- une quatrième source de courant réalisée au moyen d'un transistor 50526 de type P. Ce transistor 50526 est contrôlé par le second signal dynamique V2. La quatrième source de courant n'est activée que lorsque les moyens d'amplification 505 sont en « mode dynamique », ceci afin de limiter le courant à travers la seconde paire différentielle 50521, 50522 lorsque les moyens d'amplification 505 sont en « mode statique ».

Les première 50517 et seconde 50527 sorties amplifiées (reliées respectivement aux sources des transistors 50513 et 50523) des premier 5051 et second 5052 amplificateurs sont connectées respectivement aux grilles 50311, 50321 des premier 5031 et second 5032 transistors de sortie de l'étage de sortie 503.

On obtient ainsi, grâce à cette implantation des moyens d'amplification 505, un circuit d'interface de sortie 500 dont l'amplitude du signal de sortie peut explorer toute la plage de tension s'étendant de 0V à VCC (on parle de circuit « rail-to-rail ») et dont la pente de montée et de descente du signal de sortie 502 est la même que celle du signal programmable SLR.

On présente, en relation avec la *figure 8,* les moyens de génération 506 des premier V1 et second V2 signaux dynamiques à partir de la différence entre le signal de sortie 5021 et le signal SLR selon un mode de réalisation préférentiel de l'invention.

Les moyens de génération 506 comprennent des moyens de comparaison d'un courant dépendant de la différence entre le signal de sortie 5021 et le signal SLR et d'un courant de référence Iref.

Les moyens de comparaison comprennent des troisième 5061 et quatrième 5062 amplificateurs différentiels.

Le troisième amplificateur différentiel 5061 est un amplificateur différentiel classique comprenant une troisième paire différentielle de transistors 50611, 50612 de type P ainsi que deux autres transistors 50613, 50614 de type N. La grille du transistor 50611 de la troisième paire différentielle est reliée à la sortie 502 du circuit d'interface de sortie 500 et la grille du transistor 50612 de la troisième paire différentielle est reliée à la sortie 5044 du générateur de rampe délivrant le signal SLR.

La troisième paire différentielle 50611, 50612 du troisième amplificateur différentiel 5061 est reliée a une cinquième source de courant 50615 délivrant un courant statique. Le troisième amplificateur différentiel 5061 comprend également une sixième source de courant 50616 délivrant un courant de référence.

Le quatrième amplificateur différentiel 5062 est un amplificateur différentiel classique comprenant une quatrième paire différentielle de transistors 50621, 50622 de type N ainsi que deux autres transistors 50623, 50624 de type P. La grille du transistor 50622 de la quatrième paire différentielle est reliée à la sortie 502 du circuit d'interface de sortie 500 et la grille du transistor 50621 de la quatrième paire différentielle est reliée à la sortie 5044 du générateur de rampe délivrant le signal SLR.

La quatrième paire différentielle 50621, 50622 du quatrième amplificateur différentiel 5062 est reliée a une septième source de courant 50625 délivrant un courant statique Le quatrième amplificateur différentiel 5062 comprend également une huitième source de courant 50626 délivrant le courant de référence.

Par exemple, les cinquième 50615, sixième 50616, septième 50625 et huitième 50626 source de courant délivrent respectivement 5uA, 1uA, 5uA et 1uA.

Les première 50617 et seconde 50627 sorties (reliées respectivement aux drains des transistors 50614 et 50624) des troisième 5061 et quatrième 5062 amplificateurs différentiels sont connectées à deux entrées d'une porte logique OU 5063. La sortie de la porte OU 5063 est reliée à une première sortie 5064 délivrant le premier signal dynamique V1 et à une seconde sortie 5065 délivrant le second signal dynamique V2 via un inverseur 5066.

On explique ci-après le fonctionnement du circuit d'interface de sortie 500. On présente, en relation avec les *figures 9A à 9E,* des courbes en fonction du temps t (en microsecondes) du signal SLR (figure 9B), du premier signal dynamique V1 (figure 9C), du signal de sortie 5021 (figure 9D) et du courant IC5 de la charge C5 du circuit d'interface de sortie 500 en réponse à un signal d'entrée 5011 (figure 9A).

Les courbes de tensions sont représentées en V et le courant IC5 en mA. L'échelle de temps des courbes des figures 9A à 9D sont les mêmes que celle de la courbe de la figure 9E.

Le signal d'entrée 5011 est un signal logique dont le niveau bas est à 0 et le niveau haut est à VCC_ logique (soit environ 1,8 V).

La différence de tension entre le signal de sortie 5021 et le signal SLR est convertie en un courant, ci-après désigné par « courant différentiel » par les troisième 5061 et quatrième 5062 amplificateurs des moyens de génération 506.

Les moyens de génération 506 comparent le courant différentiel (dépendant de la différence entre le signal de sortie 5021 et le signal SLR) et le courant de référence.

Lors d'une transition du signal d'entrée 5011 (du niveau bas au niveau haut ou inversement), la différence entre le signal de sortie 5021 et le signal SLR devient supérieure à une valeur seuil, par exemple 0,5V, alors le courant différentiel dans une des troisième 50611, 50612 ou quatrième 50621, 50622 paire différentielle devient supérieur au courant de référence. En conséquence, les moyens de génération 506 donnent au premier signal dynamique V1 la valeur logique 1 et au second signal dynamique V2 la valeur logique 0, ce qui entraîne :

- une activation de la deuxième 50516 et de la quatrième 50526 source de courant dans les premier 5051 et second 5052 amplificateurs (respectivement par les premier V1 et second V2 signaux dynamique), et
- le fait que les premier et second interrupteurs connectent les première 50517 et seconde 50527 sorties amplifiés respectivement aux grilles 50311, 50321 des premier et second transistors de sortie.

Ainsi, lors d'une transition du signal d'entrée 5011, les moyens d'amplification 505 (qui fonctionnent dans le mode dynamique) et l'étage de sortie 503 forment un circuit d'interface de sortie qui est équivalent à un « amplificateur suiveur » dont l'entrée est reliée au signal délivré par le générateur de rampe 504 et dont la sortie coïncide avec la sortie 502 du circuit d'interface de sortie 500. Ceci permet d'asservir la pente de montée et de descente de la sortie 5021 à la pente de montée et de descente du signal SLR. L'activation de la deuxième 50516 et de la quatrième 50526 source de courant permet aux moyens d'amplification 505 d'asservir la tension de sortie 5021 au signal SLR pour des charges capacitives élevées sur cette sortie.

Lorsque l'on est situé entre deux transitions du signal d'entrée 5011, la différence entre le signal de sortie 5021 et le signal SLR est inférieure au seuil précité. Dans ce cas, le courant différentiel est inférieur au courant de référence. En conséquence, les moyens de génération 506 donnent aux premier V1 signal dynamique la valeur logique 0 et au second signal V2 dynamique la valeur 0, ce qui entraîne :

- une désactivation de la deuxième 50516 et de la quatrième 50526 source de courant dans les premier 5051 et second 5052 amplificateurs (respectivement par les premier V1 et second V2 signaux dynamique), et
- le fait que les premier et second interrupteurs connectent l'entrée 501 respectivement aux grilles 50311, 50321 des premier 5031 et second 5032 transistors de sortie.

Ainsi, lorsque l'on est situé entre deux transitions du signal d'entrée 5011, les moyens d'amplification 505 fonctionnent dans le mode statique, l'étage de sortie 503 est équivalent à un « inverseur » connecté au signal d'entrée 5011. Ceci permet au circuit d'interface de sortie 500 de générer en sortie des niveaux haut et des niveaux bas proches des rails d'alimentation. Cela permet également de délivrer des courants statiques importants grâce a une tension $V_{GS}$-$V_T$ élevée pour les transistors 5031 et 5032 de l'étage de sortie. La désactivation de la deuxième 50516 et de la quatrième 50526 source de courant pendant cette phase permet de réduire la consommation statique du circuit d'interface de sortie.

On présente, en relation avec la *figure 10,* plusieurs courbes en fonction du temps t (en microsecondes) de la tension de sortie 5021 du circuit d'interface de sortie 500 en réponse à un signal d'entrée 5011 sous la forme d'un échelon de tension dont le niveau bas est 0 et le niveau haut est VCC_logique appliqué à l'entrée 501 du circuit d'interface de sortie 500 respectivement pour des charges C5 dont la capacité vaut 0pF, 50pF, 100pF, 150pF, 200pF, 250pF et 300pF.

On peut se rendre compte que ces courbes sont quasiment superposées, ce qui montre que la pente maximale du signal de sortie 5021 du circuit d'interface de sortie 500 selon l'invention est quasiment indépendante de la capacité de la charge C5 .


**Revendications**

**1.** Dispositif électronique de pilotage (500) d'une charge externe (C5) recevant, en entrée un signal d'entrée et délivrant en sortie à la charge externe, un signal de sortie, **caractérisé en ce qu'**il comprend des moyens de réduction de la dépendance de la pente maximale (en Anglais « slew rate ») du signal de sortie à la capacité de la charge externe (C5), lesdits moyens de réduction de la dépendance de la pente maximale du signal de sortie à la capacité de la charge externe comprenant :

   - un générateur de rampe programmable (504) comprenant au moins une entrée (5043) sur laquelle est appliqué ledit signal d'entrée, ledit générateur de rampe délivrant un signal, dit signal délivré par le générateur de rampe, et
   - des moyens de traitement rétroactif du signal de sortie comprenant des moyens d'amplification (505) de la différence entre le signal de sortie et le signal délivré par le générateur de rampe (504), lesdits moyens de traitement rétroactif visant à égaliser sensiblement le signal de sortie avec ledit signal délivré par le générateur de rampe (504),

   les moyens d'amplification (505) comprenant au moins un premier amplificateur différentiel (5051) comprenant des transistors de type P et un second amplificateur différentiel (5052) comprenant des transistors de type N,
   **en ce que** des première et seconde paires différentielles respectivement desdits premier (5051) et second (5052) amplificateurs sont reliées respectivement :

   - à des première et troisième sources de courant statique et
   - à des seconde et quatrième sources de courant contrôlées par des premier et second signaux dynamiques,

   et **en ce que** lorsque la différence d'amplitude entre le signal de sortie et le signal délivré par le générateur de rampe (504) est supérieure à un premier seuil prédéterminé, les premier et second signaux dynamique prennent respectivement des première et seconde valeurs permettant réduire le temps de réponse des moyens d'amplification (505).

**2.** Dispositif électronique selon la revendication 1, **caractérisé en ce que** les moyens de traitement comprennent en outre des moyens de génération (506) des premier et second signaux dynamiques à partir de la différence entre le signal de sortie et le signal délivré par le générateur de rampe (504).

**3.** Dispositif électronique selon la revendication 2, **caractérisé en ce que** les moyens de génération (506) des premier et second signaux dynamiques comprennent des moyens de comparaison d'un premier courant dépendant de la différence entre le signal de sortie et le signal délivré par le générateur de rampe et d'un second courant de référence de sorte que :

   - lorsque la différence d'amplitude entre le premier courant et le second courant est supérieure ou égale à un second seuil, alors les premier et second signaux dynamiques prennent lesdites première et seconde valeurs.

**4.** Dispositif électronique selon l'une quelconque des revendications 1 à 3, ledit dispositif électronique comprenant des premier (5031) et second (5032) transistors de sortie dont les drains sont reliés à ladite sortie, **caractérisé en ce que** lesdits moyens d'amplification comprennent des premier (5071) et second (5072) interrupteurs qui:

   - connectent ladite entrée (501) respectivement aux grilles (50311, 50321) des premier (5031) et second (5032) transistors de sortie, lorsque la différence d'amplitude entre le signal de sortie et le signal délivré par le générateur de rampe est inférieure audit premier seuil ;
   - connectent des première (50517) et seconde (50527) sorties amplifiés respectivement desdits premier (5051) et second amplificateurs (5052) aux grilles (50311, 50321) des premier (5031) et second (5032) transistors de sortie, lorsque la différence d'amplitude entre le signal de sortie et le signal délivré par le générateur de rampe (504) est supérieure ou égale audit premier seuil.

**5.** Dispositif électronique selon la revendication 4, **caractérisé en ce que** lorsque la différence d'amplitude entre le signal de sortie et le signal délivré par le générateur de rampe (504) est supérieure ou égale audit premier seuil, un circuit d'interface de sortie, comprenant les moyens d'amplification (505) et lesdits premier (5031) et second (5032) transistors de sortie, forme un amplificateur suiveur dont l'entrée est reliée au signal (SLR) délivré par le générateur de rampe et dont la sortie coïncide avec la sortie (502) du dispositif électronique de pilotage (500).

6. Dispositif électronique selon les revendications 3 à 5, **caractérisé en ce que** les premier et second seuils sont tels que lorsque la différence d'amplitude entre le signal de sortie et le signal délivré par le générateur de rampe est supérieure ou égale audit premier seuil, alors la différence d'amplitude entre les premier et second courants est supérieure au second seuil et **en ce que** lorsque la différence d'amplitude entre le signal de sortie et le signal délivré par le générateur de rampe est inférieure audit premier seuil, alors la différence d'amplitude entre les premier et second courants est inférieure au second seuil.

7. Dispositif électronique selon l'une quelconque des revendications 1 à 6 **caractérisé en ce que** le générateur de rampe programmable comprend une source de courant.

8. Composant intégré, **caractérisé en ce qu'**il comprend un dispositif électronique de pilotage d'une charge externe (C5) selon l'une quelconque des revendications 1 à 7.

Fig. 1

Fig. 2A

Fig. 2B

Fig. 2C

Fig. 2D

Fig. 2E

Fig. 3A

Fig. 3B

Fig. 3C

Fig. 3D

Fig. 3E

Fig. 4A

Fig. 4B

Fig. 5

EP 1 826 905 A1

Fig. 6

Fig. 7

Fig. 8

Fig. 9A

Fig. 9B

Fig. 9C

Fig. 9D

Fig. 9E

Fig. 10

**Office européen des brevets**

## RAPPORT DE RECHERCHE EUROPEENNE

Numéro de la demande

EP 07 10 2197

### DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A | US 6 107 833 A (YOSHIDA KENICHI [JP]) 22 août 2000 (2000-08-22) * le document en entier * ----- | 1-8 | INV. H03K19/003 H03K17/16 |
| A | US 2003/052369 A1 (KAJIMOTO TAKESHI [JP]) 20 mars 2003 (2003-03-20) * alinéa [0149] - alinéa [0153]; figures 1,7 * * alinéa [0071] - alinéa [0095] * ----- | 1-8 | |
| A | US 2005/116749 A1 (PENTAKOTA VISVESVARAYA [IN] ET AL) 2 juin 2005 (2005-06-02) * le document en entier * ----- | 1,7,8 | |
| A | EP 0 164 615 A2 (IBM [US]) 18 décembre 1985 (1985-12-18) * le document en entier * ----- | 1 | |
| A | US 5 598 119 A (THAYER BILLY E [US] ET AL) 28 janvier 1997 (1997-01-28) * le document en entier * ----- | 1 | DOMAINES TECHNIQUES RECHERCHES (IPC) |
| A | US 2004/257127 A1 (LEVIN ALEXANDER [US] ET AL) 23 décembre 2004 (2004-12-23) * le document en entier * ----- | 1 | H03K H04L H03F |

Le présent rapport a été établi pour toutes les revendications

| Lieu de la recherche | Date d'achèvement de la recherche | Examinateur |
|---|---|---|
| La Haye | 4 juillet 2007 | Jepsen, John |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

......................................................................
& : membre de la même famille, document correspondant

EPO FORM 1503 03.82 (P04C02)

**ANNEXE AU RAPPORT DE RECHERCHE EUROPEENNE**
**RELATIF A LA DEMANDE DE BREVET EUROPEEN NO.**            EP 07 10 2197

La présente annexe indique les membres de la famille de brevets relatifs aux documents brevets cités dans le rapport de
recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

04-07-2007

| Document brevet cité au rapport de recherche | | Date de publication | Membre(s) de la famille de brevet(s) | | Date de publication |
|---|---|---|---|---|---|
| US 6107833 | A | 22-08-2000 | JP | 3042478 B2 | 15-05-2000 |
| | | | JP | 11163707 A | 18-06-1999 |
| US 2003052369 | A1 | 20-03-2003 | DE | 10237536 A1 | 24-04-2003 |
| | | | JP | 2003087110 A | 20-03-2003 |
| | | | KR | 20030024567 A | 26-03-2003 |
| US 2005116749 | A1 | 02-06-2005 | AUCUN | | |
| EP 0164615 | A2 | 18-12-1985 | DE | 3582086 D1 | 18-04-1991 |
| | | | JP | 61004319 A | 10-01-1986 |
| | | | US | 4567378 A | 28-01-1986 |
| US 5598119 | A | 28-01-1997 | FR | 2732840 A1 | 11-10-1996 |
| | | | GB | 2299720 A | 09-10-1996 |
| | | | JP | 3709006 B2 | 19-10-2005 |
| | | | JP | 8288813 A | 01-11-1996 |
| | | | SG | 34253 A1 | 06-12-1996 |
| US 2004257127 | A1 | 23-12-2004 | AUCUN | | |

EPO FORM P0460

Pour tout renseignement concernant cette annexe : voir Journal Officiel de l'Office européen des brevets, No.12/82